Europäisches Patentamt

European Patent Office

Office européen des brevets

(19)

(11) **EP 1 141 744 B1**

(12) **EUROPÄISCHE PATENTSCHRIFT**

(45) Veröffentlichungstag und Bekanntmachung des Hinweises auf die Patenterteilung:
**24.09.2003 Patentblatt 2003/39**

(21) Anmeldenummer: **99960897.9**

(22) Anmeldetag: **11.11.1999**

(51) Int Cl.$^7$: **G01S 7/40**, H03L 7/02

(86) Internationale Anmeldenummer:
**PCT/DE99/03595**

(87) Internationale Veröffentlichungsnummer:
**WO 00/028349 (18.05.2000 Gazette 2000/20)**

(54) **VERFAHREN ZUR DETEKTION UND KORREKTUR VON NICHTLINEARITÄTEN HOCHFREQUENTER, SPANNUNGSGESTEUERTER OSZILLATOREN**

METHOD FOR DETECTING AND CORRECTING NON-LINEARITIES OF HIGH-FREQUENCY VOLTAGE-CONTROLLED OSCILLATORS

PROCEDE DE DETECTION ET DE CORRECTION DE NON-LINEARITES D'OSCILLATEURS COMMANDES EN TENSION HAUTE FREQUENCE

(84) Benannte Vertragsstaaten:
**DE ES FR GB IT SE**

(30) Priorität: **11.11.1998 DE 19852017**

(43) Veröffentlichungstag der Anmeldung:
**10.10.2001 Patentblatt 2001/41**

(73) Patentinhaber: **SIEMENS AKTIENGESELLSCHAFT**
**80333 München (DE)**

(72) Erfinder: **KUNERT, Martin**
**D-93073 Neutraubling (DE)**

(56) Entgegenhaltungen:
**WO-A-98/37705          US-A- 5 799 534**

EP 1 141 744 B1

**Beschreibung**

Die Erfindung betrifft ein Verfahren zur Detektion und Korrektur von Nichtlinearitäten hochfrequenter, spannungsgesteuerter Oszillatoren, wie sie insbesondere in Form von Mikrowellen-Oszillatoren für Radaranwendungen in Kraftfahrzeugen eingesetzt werden.

Die Radartechnik ist für den rauhen Einsatz im Automobil oder der Industrie zum Zweck einer berührungslosen Erfassung der Entfernung, Geschwindigkeit, Beschaffenheit, Anwesenheit oder dergleichen von Objekten besonders geeignet. Funktionalität, Meßgenauigkeit und Kosten von Radarsensoren hängen dabei wesentlich vom angewandten Modulationsverfahren und der zugehörigen Radar-Signalverarbeitung ab.

Bei dem häufig zur Abstandsmessung verwendeten FMCW-Radarprinzip (FMCW = frequency modulated continous wave) hängt die Qualität des Meßwertes u. a. von der Frequenzgenauigkeit und -stabilität des Mikrowellen-Oszillators ab. Diese Größen werden in der Praxis vor allem durch Temperaturdrift, Rauschen und Nichtlinearitäten des Oszillators beeinflußt und müssen deshalb in der Regel überwacht werden.

Die berührungslose Abstands- und Geschwindigkeitsmessung mit Radar ist seit langem bekannt und entstammt der Militärtechnik. Bei dem bereits erwähnten FMCW-Verfahren, auf dessen Basis das in der EP 0 727 051 B1 beschriebene Verfahren zum Betreiben eines Radargerätes funktioniert, wird ein frequenzmoduliertes Radarsignal ausgesendet, daß phasen- bzw. frequenzverschoben empfangen wird. Die gemessene Phasen- bzw. Frequenzdifferenz, die typischerweise im kHz-Bereich liegt, ist proportional zum Objektabstand, vorausgesetzt die Frequenzmodulation erfolgt zeitlich linear. In der Praxis ist diese Voraussetzung oftmals nur unzureichend erfüllt.

Die Nichtlinearitäten bei der Frequenzmodulation werden in erster Linie durch die spannungsgesteuerten Oszillatoren verursacht, da diese bauteilebedingt eine nichtlineare Spannungs/Frequenz-Kennlinie aufweisen. Darüber hinaus zeigen diese Oszillatoren ein mehr oder weniger stark ausgeprägtes Phasenrauschen, das im Vergleich zur spannungsabhängigen Nichtlinearität wesentlich höherfrequenter ist und bei kurzen Entfernungen - der sogenannten Korrelationslänge des Radars - in der Regel vernachlässigt werden kann.

Eine Kompensation der spannungsabhängigen Nichtlinearitäten ist hingegen unbedingt erforderlich, um eine einwandfreie Objektdetektion mit der Radareinrichtung durchführen zu können. Da sich die Nichtlinearitaten beispielsweise durch Temperatur- oder Alterungseffekte ändern, muß eine Korrektur ständig angepaßt werden, um Linearitätsabweichungen im Toleranzbereich von maximal 1 % des Meßwertes zu halten.

Aus dem Stand der Technik sind entsprechende Korrekturverfahren bekannt:

- Der Oszillator kann mit einer einmalig vorbestimmten, vorverzerrten Steuerspannung angesteuert werden. Diese Methode ist jedoch nur bedingt tauglich, da Exemplarstreuungen des Oszillators sowie nachfolgende Frequenzschwankungen und Temperaturdriften konzeptbedingt nicht kompensiert werden.

- Aus der Druckschrift WO 98/37705 ist ein dynamisches, selbst einstellendes Synchronisationssystem für einen spannungsgesteuerten Oszillator bekannt, bei dem das Ausgangssignal des Oszillators in einen Zielfrequenzbereich, dessen Frequenz kleiner als die des Oszillator-Ausgangssignals ist, heruntergeteilt wird. Durch eine Zähleinrichtung werden während einer wählbaren Torzeit Frequenz-Zählerwerte derart akkumuliert, dass bei maximaler Frequenz des Oszillator-Ausgangssignals ein maximaler Zählerwert erreicht wird. Durch einen Mikroprozessor wird der jeweilige Zählerwert in einen spannungsäquivalenten Wert umgewandelt. Von einer Steuerschaltung wird schließlich durch Verknüpfung des spannungsäquivalenten Werts mit einem vorgegebenen Sollwert ein frequenzgangkorrigiertes Steuersignal für den Oszillator erzeugt.

- Zur Füllstandsmessung mit Hilfe von Radartechnologie ist aus der Druckschrift US 5 799 534 ein Verfahren bekannt, bei dem ebenfalls das Ausgangssignal eines spannungsgesteuerten Oszillators in einen Zielfrequenzbereich, dessen Frequenz kleiner als die des Oszillator-Ausgangssignals ist, heruntergeteilt wird. Mittels einer Zähleinrichtung werden Frequenz-Zählerwerte erfasst. Diese Zählerwerte werden anschließend in einen spannungsäquivalenten Wert umgewandelt. Abhängig von diesem Wert wird ein frequenzgangkorrigiertes Steuersignal für den Oszillator erzeugt.

- Aus dem Fachaufsatz von P. Lowbridge et al. "A low Cost mm-Wave Cruise Control System for Automotive Applications" in Microwave Journal, October 1993, ist der Einsatz einer Riegelschleife bekannt, die eine PLL-(= Phase Lock Loop-) oder AFC (= Automatic Frequency Control-) Schaltung umfaßt. Bei beiden Verfahren wird eine frequenzabhängige Referenzspannung erzeugt, die in Kombination mit einer linearen Rampe die Ansteuerspannung des Oszillators derart adaptiert, daß die Frequenzmodulation zeitlich linear verläuft. Eine derartige Regelelektronik hat jedoch den Nachteil, zu teuer und unflexibel zu sein.

- Aus der Fachveröffentlichung von Nalezinski et al. "Novel Heterodyne 24GHz FMCW Radar with High-Precision 2,4GHz SAW Reference Path" in MIOP'97 Conference Proceedings ist der Einsatz einer Referenzstrecke innerhalb der Radaranordnung bekannt, die aufgrund ihrer definierten und genau bekannten Verzögerungszeit dem störgrößenfreien Referenzsignal eines virtuellen Reflexionspunktes entspricht, dessen Entfernung durch eine Soll-Verzögerungszeit bestimmt ist. Durch Analyse und Auswertung dieses Signals ist eine Korrektur von realen Signalen mit ähnlichen Verzögerungszeiten möglich. Dieses Verfahren ist jedoch dahingehend von Nachteil, daß die zusätzliche Referenzstrecke und die ihr zugeordnete Auswerteeinheit operativ aufwendig und damit kostenintensiv ist. Letzteres ist gerade im Hinblick auf die Verwendung solcher Radarsensoren als Massenbauteil in Kraftfahrzeugen nicht akzeptabel.

Ausgehend von der geschilderten Problematik zum Stand der Technik liegt der Erfindung die Aufgabe zugrunde, ein Verfahren zur Detektion und Korrektur von Nichtlinearitäten hochfrequenter, spannungsgesteuerter Oszillatoren anzugeben, das extrem einfach und damit kostengünstig in einen leistungsfähigen Radarsensor implementierbar ist.

Diese Aufgabe wird durch das im Anspruch 1 angegebene Verfahren gelöst. Der Kern der Erfindung liegt dabei darin, im Gegensatz zu den beim Stand der Technik eingesetzten Verfahren den zeitlichen Verlauf des Ausgangssignals des Oszillators ohne ein Referenzsignal durch direkte Messung zu bestimmen. Letztere wird durch das Herunterteilen des Ausgangssignals des Oszillators um einen Vorteilerfaktor erleichtert. Letzterer ist vorzugsweise so gewählt, daß der Zielfrequenzbereich in einem für Standardlogikbausteine verarbeitbaren Frequenzbereich liegt. Mittels einer Zähleinrichtung, wie beispielsweise eines Digitalzählers, wird das heruntergeteilte Ausgangssignal direkt analysiert, wodurch entsprechende Frequenz-Zählerwerte erfaßt werden.

Aufgrund des erfindungsgemäßen Verfahrens ergeben sich verschiedene erhebliche Vorteile gegenüber dem Stand der Technik. So wird eine direkte Messung des Absolutwertes des Oszillator-Ausgangssignals vorgenommen. Ein Referenzsignal ist bei der Auswertung und Generierung einer Korrektur für Nichtlinearitäten nicht notwendig. Durch eine direkt-digitale Frequenzerfassung ist keine Kompensation von Einflußgrößen wie Temperaturdrift, Alterung usw. notwendig. Ferner kann das erfindungsgemäße Verfahren - wie anhand der Ausführungsbeispiele noch näher erläutert wird - mit einer denkbar geringen Anzahl notwendiger Komponenten im Vergleich zu den eingangs geschilderten Verfahren gemäß dem Stand der Technik implementiert werden. Schließlich kann die Bandbreite des Regelkreises durch Einstellen einer bestimmten Torzeit für die Zähleinrichtung in weiten Grenzen eingestellt und für den jeweiligen Oszillator optimiert werden. Schließlich ist eine einfache Funktionsüberprüfung des spannungsgesteuerten Oszillators und eine hohe Flexibilität bei der Linearisierung durch den Einsatz eines Mikrocontrollers möglich.

Eine bevorzugte Ausführungsform des erfindungsgemäßen Verfahrens ist im übrigen in dem Unteranspruch 2 angegeben.

Der Anspruch 1 bezieht sich auf ein Verfahren zur Detektion und Korrektur von Nichtlinearitäten von hochfrequenten, spannungsgesteuerten Oszillatoren, bei dem die Korrektur von Nichtlinearitäten durch eine entsprechende Anpassung des Zeitpunktes der Abtastung der Radar-Empfangssignale vorgenommen wird. Dieses Vorgehen kann als "frequenzanstiegskonstante Signalabtastung" umschrieben werden, die im Zuge der folgenden Beschreibung eines Ausführungsbeispiels noch näher erläutert wird.

In diesem Zusammenhang zeigen:

Figur 1    ein Blockschaltbild einer Vorrichtung zur Detektion und Korrektur von Nichtlinearitäten eines Oszillators und

Figur 2    ein schematisches Schaubild zur Darstellung der frequenzanstiegskonstanten Signalabtastung.

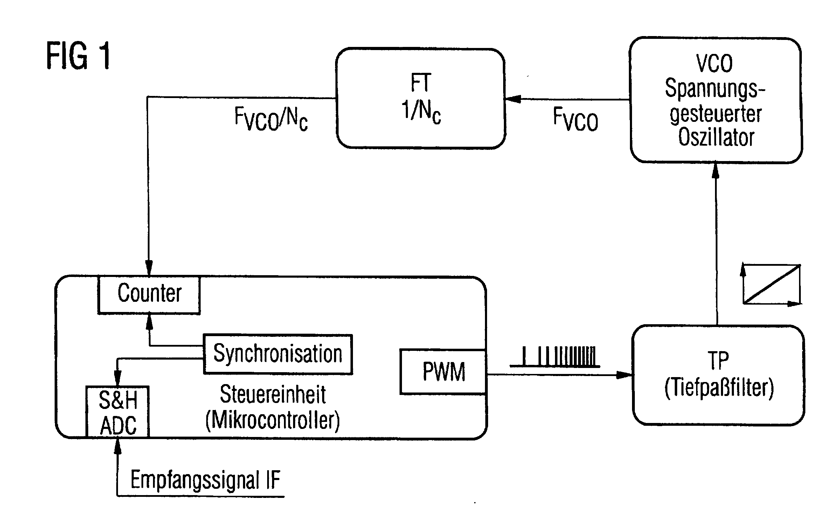

In Figur 1 ist mit VCO ein spannungsgesteuerter Mikrowellen-Oszillator bezeichnet, der ein Ausgangssignal $F_{VCO}$ aussendet. Dieses liegt typischerweise im GHz-Bereich, beispielsweise bei 24 GHz. Beim FMCW-Verfahren wird das Ausgangssignal vom Oszillator VCO moduliert, d. h. typischerweise mit einer summierten Anstiegs- und Abfallzeit von 5 ms und einem Frequenzhub von maximal 1 GHz sägezahnartig um die Grundfrequenz variiert.

Es wird ein Mikrocontroller MC eingesetzt, der verschiedene Funktionen hinsichtlich des erfindungsgemäßen Verfahrens in sich vereint. So ist er mit einem Zähler C versehen, dessen Eingang mit dem Frequenzteiler FT verbunden ist. Der Frequenzteiler FT reduziert das im GHz-Bereich liegende Ausgangssignal $F_{VCO}$ des Oszillators VCO um den Vorteilerfaktor $1/N_c$ auf vom Mikrocontroller MC verarbeitbare Werte. Über den Zähler wird dieses Signal $F_{VCO}/N_c$ erfaßt.

Der Mikrocontroller MC gibt eine lineare Ansteuerspannung S für den Oszillator VCO über den in der Regel bei Mikrocontrollern vorhandenen Pulsweitenmodulationsausgang PWM aus, welche über ein Tiefpaßfilter TP dem Oszillator VCO aufgegeben wird. Nichtlinearitäten im Ausgangssignal $F_{VCO}$ werden dabei nicht berücksichtigt.

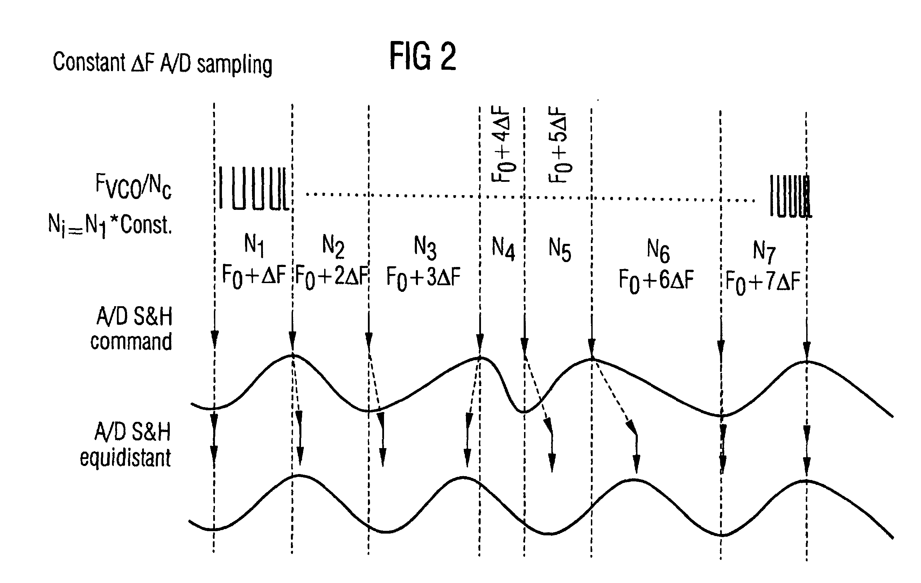

Eine Analyse und Korrektur der Nichtlinearitäten findet vielmehr auf der Seite der Empfangssignal-Erfassung und -Verarbeitung in der Radareinheit statt. Demnach sind - wie aus Figur 2 deutlich gemacht wird - die Register des Zählers C mit Zählerständen $N_1, N_2 ... N_7$ vorbelegt, die einem linearen Frequenzanstieg entsprechen. Sie genügen also der Beziehung

$$N_e = F_0 + i \cdot \Delta F$$

mit i = 0, 1, 2 ...

Das heruntergeteilte Signal $F_{VCO}/N_C$ wird in den einzelnen Registern heruntergezählt und es wird dann eine Analog-Digital-Wandlung des Empfangssignals IF vorgenommen, wenn ein Register abgezählt, also der Zählerstand = 0 erreicht worden ist. Bei Auftreten dieses Ereignisses - also zu den Zeitpunkten $t_1$, $t_2$, $t_3$ ... in Figur 2 - startet der Mikrocontroller MC die Signalaufnahme des Analog-Digital-Wandlers ADC, dem das Empfangssignal IF zugeführt wird. Hierbei kann z. B. das Sample-And-Hold-Abtasthalteglied S&H getriggert werden. Mit den dabei erhaltenen, abgetasteten A/D-Wandlerwerten werden üblich Signalverarbeitungsalgorithmen durchgeführt, wie z. B. eine schnelle Frequenztransformation (Fast Fourier Transformation). Aufgrund des vorstehend erläuterten Verfahrens ergäben sich bei einem streng linearen Frequenzverlauf des Ausgangssignals $F_{VCO}$ des Oszillators zwangsläufig äquidistante Signalaufnahmepunkte, nämlich z. B. die Zeitpunkte $t_1'$, $t_2'$, $t_3'$ ... in Figur 2. Bei entsprechenden Nichtlinearitäten im Ausgangssignal $F_{VCO}$ verschiebt sich der Aufnahmezeitpunkt entsprechend der Signalverzerrungen durch Nichtlinearitäten. Da nun Signalverarbeitungsalgorithmen im Normalfall von äquidistanten Abtastzeitpunkten ausgehen, erfolgt durch die beschriebene Vorgehensweise eine automatische Verschiebung der Aufnahmezeitpunkte entsprechend den Nichtlinearitäten, welche hierdurch korrigiert werden. Damit geht eine automatische Signalentzerrung einher, die prinzipbedingt absolut echtzeitfähig ist und keiner Regelschleife bedarf. Im übrigen kann durch eine geeignete Wahl des Vorteilerfaktors $N_C$ die für eine Signalverarbeitung benötigte Abtastrate $F_{A/D}$ eingestellt werden.

**Patentansprüche**

1. Verfahren zur Detektion und Korrektur von Nichtlinearitäten von hochfrequenten, spannungsgesteuerten Oszillatoren, insbesondere von Mikrowellen-Oszillatoren für Radaranwendungen in Kraftfahrzeugen, mit folgenden Verfahrensschritten:

   - Ansteuern des Oszillators (VCO) mit einer linearen Steuerspannung ($S_{lin}$),
   - Herunterteilen des Ausgangssignals ($F_{VCO}$) des Oszillators (VCO) um einen Vorteilerfaktor ($1/N_C$) mittels eines Frequenzteilers (FT) in einen Zielfrequenzbereich, der um mindestens eine Größenordnung kleiner als das Oszillator-Ausgangssignal ($F_{VCO}$) ist,
   - direktes Analysieren des heruntergeteilten Ausgangssignals ($F_{VCO}/N_C$) mittels einer Zähleinrichtung (C), wobei Register ($N_1$, $N_2$ ...) der Zähleinrichtung (C) mit voreingestellten Zählerständen belegt sind, die einem linearen Frequenzgang des Ausgangssignals ($F_{VCO}$) entsprechen, und wobei nacheinander in den Registern ($N_1$, $N_2$ ...) entsprechend dem analysierten, tatsächlichen Verlauf des heruntergeteilten Ausgangssignals ($F_{VCO}/N_C$) heruntergezählt wird und bei Erreichen des Wertes O im Register ($N_1$, $N_2$ ...) eine Signalabtastung eines Empfangssignals (IF) vorgenommen wird.

2. Verfahren nach Anspruch 1, **dadurch gekennzeichnet, daß** die Signalabtastung des Empfangssignals (IF) durch die Triggerung des Sample-And-Hold-Abtasthaltegliedes (S&H) eines Analog-Digital-Wandlers (ADC) mittels der Zähleinrichtung (C) initiiert wird.

**Claims**

1. Method for detection and correction of nonlinearities in radio-frequency voltage controlled oscillators, in particular in microwave oscillators for radar applications in motor vehicles, comprising the following method steps:

   - actuation of the oscillator (VCO) with a linear control voltage ($S_{lin}$),
   - division of the output signal ($F_{VCO}$) of the oscillator (VCO) by an initial division factor ($1/N_c$) by means of a frequency divider (FT) to a target frequency band which is at least one order of magnitude lower than that oscillator output signal ($F_{VCO}$),
   - direct analysis of the divided output signal ($F_{VCO}/N_C$) by means of a counting device (C) with registers ($N_1$, $N_2$ ...) of the counting device (C) being loaded with preset counts, which correspond to a linear frequency response of the output signal ($F_{VCO}$), and with the registers ($N_1$, $N_2$, ...) being counted down successively on the basis of the analysed, actual profile of the divided output signal ($F_{VCO}/N_C$) and signal sampling from a received signal (IF) being carried out when the value 0 is reached in the register ($N_1$, $N_2$, ...).

2. Method according to Claim 1, **characterized in that** the signal sampling from the received signal (IF) is initiated by triggering a sample-and-hold element (S&H) in an analogue/digital converter (ADC) by means of the counting device (C).

**Revendications**

1. Procédé de détection et de correction des défauts de linéarité des oscillateurs à haute fréquence commandés en tension, plus particulièrement des oscillateurs à hyperfréquences pour les applications radar dans les véhicules automobiles, comprenant les étapes de procédé suivantes :

- commande de l'oscillateur (VCO) avec une tension de commande linéaire ($S_{lin}$),
- réduction de la fréquence du signal de sortie ($F_{VCO}$) de l'oscillateur (VCO) d'un facteur de pré-division ($1/N_C$) au moyen d'un diviseur de fréquence (FT) dans une gamme de fréquences cible qui est inférieure d'au moins un ordre de grandeur à celle du signal de sortie de l'oscillateur ($F_{VCO}$),
- analyse directe du signal de sortie réduit en fréquence ($F_{VCO}/N_C$) au moyen d'un dispositif de comptage (C), les registres ($N_1$, $N_2$, ...) du dispositif de comptage (C) contenant des valeurs de comptage prédéfinies qui correspondent à un pas de fréquence linéaire du signal de sortie ($F_{VCO}$), et les valeurs des registres ($N_1$, $N_2$, ...) étant successivement décrémentées en fonction de l'évolution réelle analysée du signal de sortie réduit en fréquence ($F_{VCO}/N_C$) et, lorsque la valeur 0 est atteinte dans le registre ($N_1$, $N_2$, ...), il se produit un échantillonnage d'un signal reçu (IF).

2. Procédé selon la revendication 1, **caractérisé en ce que** l'échantillonnage du signal reçu (IF) est initié par le déclenchement de l'échantillonneur-bloqueur (S&H) d'un convertisseur analogique/numérique (ADC) à l'aide du dispositif de comptage (C).

FIG 1

Constant ΔF A/D sampling

FIG 2

$F_{VCO}/N_c$

$N_i = N_1 \cdot Const.$

$F_0 + 4\Delta F$    $F_0 + 5\Delta F$

$N_1$    $N_2$    $N_3$    $N_4$    $N_5$    $N_6$    $N_7$

$F_0 + \Delta F$  $F_0 + 2\Delta F$  $F_0 + 3\Delta F$    $F_0 + 6\Delta F$  $F_0 + 7\Delta F$

A/D S&H
command

A/D S&H
equidistant

EP 1 141 744 B1